# EUROPÄISCHE PATENTSCHRIFT

(11) **EP 1 502 976 B1**
(45) Veröffentlichungstag und Bekanntmachung des Hinweises auf die Patenterteilung: **18.04.2007**
(21) Anmeldenummer: 04005979.2
(22) Anmeldetag: 12.03.2004
(51) Int. Cl.: D02G 3/12, D02G 3/44, D02G 3/38

(54) **Garne und Gewebe zur Abschirmung elektromagnetischer Strahlung**
Yarn and fabric for shielding against electromagnetic rays
Fils et tissus pour la protection d'ondes électromagnétiques

(30) Priorität: 24.07.2003 DE 20311375 U
(43) Veröffentlichungstag der Anmeldung: 02.02.2005
(73) Patentinhaber: W. Zimmermann GmbH & Co.KG, 88171 Weiler-Simmerberg (DE)
(72) Erfinder: Nusko, Robert, Dr., 93109 Wiesent (DE); Parzl, Adi, 93059 Regensburg (DE); Maier, Georg, Dr., 93177 Altentann (DE)
(74) Vertreter: Kritzenberger, Jürgen Hermann

(56) Entgegenhaltungen:
- EP-A- 0 911 435
- EP-A- 1 327 709
- DE-A- 10 242 785
- US-A- 5 632 137

## Beschreibung

### Technisches Gebiet

Die vorliegende Erfindung betrifft Garne, Gewebe, Gestricke, Gewirke und textile Produkte zur Abschirmung elektromagnetischer Strahlung.

### Stand der Technik

Mit der zunehmenden Verbreitung elektronischer Geräte und mobiler Kommunikationseinheiten steigt der Bedarf nach Abschirmung insbesondere von hochfrequenter elektromagnetischer Strahlung. Dieser Bedarf nach Abschirmung kann technische oder gesundheitliche Gründe haben. Gerade die gepulste, hochfrequente Strahlung der nahe am Körper getragenen mobilen Kommunikationsgeräte ist mit ihren schwer zu verifizierenden Auswirkungen häufig Gegenstand der öffentlichen Diskussion. Zum Schutz von Personen, die mobile Kommunikatoren mit sich führen, wurden verschiedene Lösungsansätze verfolgt. Bei einer Entwicklung handelt es sich um Textilien, in die zur Erzielung eines abschirmenden Effektes metallische Drähte eingearbeitet werden. Die Einarbeitung der Drähte kann wiederum auf verschiedene Arten erfolgen.

In der CH 690 686 wird z. B. die Herstellung eines Verbundgarns aus textiler Lunte und monofilem, lackiertem Metallfaden beschrieben. Während des Garnspinnprozesses auf einer Ringspinnmaschine wird der Lunte zentral ein beschichteter Metalldraht zugeführt. In der dem Spinnprozess nachgeschalteten thermischen Behandlung verklebt die schmelzende Beschichtung den zentralen Draht mit der gesponnenen textilen Umhüllung. Als Ergebnis erhält man ein textiles Garn, das überwiegend im Inneren einen einzelnen isolierten Draht enthält. Um die textilen Eigenschaften des Garns möglichst wenig zu beeinträchtigen ist die Drahtstärke auf einen Durchmesser kleiner 20 µm beschränkt.

Desweiteren beschreiben die EP 644 283 und die EP 250 260 Umwinde- bzw. Zwirntechniken zur Einarbeitung eines leitfähigen Filaments in ein Garn. Daneben kann zur Herstellung abschirmender Gewebe auch ein direktes Einweben von Metalldrähten, Metallmultifilamentgarnen, Metall/Textilstapelgarnen oder metallisierten Garnen erfolgen. Ferner besteht die Möglichkeit des Metallisierens textiler Gewebe.

Die EP-A-0 911 435 offenbart ein Garn zur Abschirmung von elektromagnetischer Strahlung, umfassend zumindest einen Kernfaden, zumindest ein, um den Kernfaden gewundenes elektrisch leitfähiges Multifilamentgarn und zumindest einen, um den mit dem elektrisch leitfähigen Multifilamentgarn umwundenen Kernfaden gewundenen äußeren Umwindefaden, wobei das elektrisch leitfähige Multifilamentgarn aus mindestens zwei und maximal vier im Wesentlichen parallel laufenden Einzelfilamenten besteht.

Neben dem Einsatz in am Körper getragenen Taschen für mobile Kommunikationseinrichtungen werden die genannten Garne / Gewebe u. a. in Baldachinen, Vorhängen, Teppichen, Sitzbezügen, Schutzbekleidung, Unterwäsche und Bettwäsche eingearbeitet. Vor allem bei Anwendungen direkt am menschlichen Körper steht die Anforderung einer möglichst effektiven elektromagnetischen Abschirmung im Mega- bis Gigahertzbereich bei gleichzeitig hohem textilen Tragekomfort im Vordergrund. Diese Kriterien werden durch die aus dem Stand der Technik bekannten abschirmenden Garne bzw. Gewebe nur unzureichend erfüllt:
- Garne mit nur einem Draht als elektrisch leitfähige Komponente schirmen bei geringem Drahtdurchmesser schlecht ab und zeigen bei großem Drahtdurchmesser schlechte textile Eigenschaften.
- Gewebe mit elektrisch voneinander isolierten Garnen schirmen schlecht ab.
- Eingewebte Metalle bedecken nur einen geringen Flächenanteil des Gewebes, wodurch eine unzureichende Abschirmung bewirkt wird.
- Metallisierte Gewebe besitzen eine komplett metallisierte Oberfläche, was zu einem schlechten Tragekomfort führt.
- Gut abschirmende Stapelfasern aus Metall- und Textilgarn besitzen sehr große Metallgehalte, wodurch ebenfalls ein schlechter Tragekomfort bewirkt wird.
- Stapelfasern aus Metall- und Textilgarn mit relativ geringem Metallgehalt sind für eine gute Abschirmung zu wenig elektrisch leitfähig.

Es besteht daher weiterhin ein Bedarf an Garnen, die zu Geweben verarbeitet werden können, welche mit hoher Effizienz elektromagnetische Strahlung abschirmen und die gleichzeitig diesen Geweben einen guten textilen Charakter verleihen.

### Darstellung der Erfindung

Hier setzt die Erfindung an. Der Erfindung, wie sie in den Ansprüchen gekennzeichnet ist, liegt die Aufgabe zugrunde, Garne bereitzustellen, die eine gute Abschirmung von elektromagnetischer Strahlung bewirken und gleichzeitig einen hohen textilen Charakter aufweisen.

Diese Aufgabe wird erfindungsgemäß durch das Garn gemäß Anspruch 1, das Gewebe, Gestrick oder Gewirk gemäß Anspruch 15, die textilen Produkte gemäß Anspruch 18 und die Verwendung des Garns nach Anspruch 20 gelöst. Weitere vorteilhafte Details, Aspekte und Ausgestaltungen der vorliegenden Erfindung ergeben sich aus den abhängigen Ansprüchen, der Beschreibung, den Beispielen und den Figuren.

Die erfindungsgemäßen Garne zur Abschirmung elektromagnetischer Strahlung umfassen zumindest einen Kernfaden, zumindest ein, um den Kernfaden gewundenes elektrisch leitfähiges Multifilamentgarn und zumindest einen, um den mit dem elektrisch leitfähigen Multifilamentgarn umwundenen Kernfaden gewundenen äußeren Umwindefaden. Das elektrisch leitfähige Multifilamentgarn besteht aus wenigstens zwei im Wesentlichen parallel laufenden Einzelfilamenten und umfasst ein metallisiertes, textiles Multifilamentgarn.

Der Kernfaden kann in einer für die jeweilige Applikation geeigneten Form eingesetzt werden. Beispielhaft seien einige Varianten genannt: Monofil, Multifil, segmentierte Typen und texturierte Typen. Falls erforderlich, können auch mehrere Fäden parallel oder verzwirnt im Kern eingesetzt werden. Es können gleichartige oder unterschiedliche Fäden nebeneinander verwendet werden.

Der Kernfaden übernimmt im Wesentlichen die Funktion eines textilen Trägers der Garnkonstruktion. Er beeinflusst maßgeblich die Reißfestigkeit, die Dehnbarkeit und die Stärke des Garns. Zusammen mit dem äußeren Umwindefaden bestimmt er die Wasseraufnahme und insbesondere die Schweißaufnahme und den Abtransport dieser Flüssigkeiten. Prinzipiell eignen sich alle Garne mit ausreichender Festigkeit als Kernfaden. Es können also grundsätzlich auch Monofilamentgarne verwendet werden, bevorzugt werden jedoch Multifilamentgarne aus üblichen textilen Werkstoffen wie z. B. Polyester, Polyamid, Viskose, Baumwolle und deren Gemischen. Diese Multifilamentgarne weisen gegenüber Monofilamentgarnen wesentlich bessere Knickeigenschaften auf. Neben den genannten plastischen, nur in geringem Umfang dehnbaren Materialien sind gummielastische Werkstoffe wie z. B. Fäden aus Natur- oder Synthesegummis ebenfalls zum Einsatz als Kernfaden geeignet.

Das um den Kernfaden gewundene Multifilamentgarn weist eine elektrische Leitfähigkeit auf, wodurch die elektromagnetische Strahlung effizient abgeschirmt werden kann. Multifilamentgarne legen sich bei der Umwindung eines Kerns bevorzugt flächig auf den Kernfaden, so dass sie bei gleichem Außendurchmesser eine im Vergleich zum Monofil deutlich höhere Flächenabdeckung bewirken. Erfindungsgemäß besteht das elektrisch leitfähige Multifilamentgarn aus wenigstens zwei im Wesentlichen parallel laufenden Einzelfilamenten. Prinzipiell kann als elektrisch leitfähiges Multifilamentgarn jedes elektrisch leitende Multifilamentgarn mit wenigstens zwei Einzelfilamenten verwendet werden. Bevorzugt werden Multifilamentgarne mit hoher Oberflächenleitfähigkeit eingesetzt.

Durch die elektrische Leitfähigkeit an der Oberfläche wirkt das Garn als Reflexionsschirm für elektromagnetische Strahlung im Kilo- bis Gigahertzbereich. Bei den Versuchen zur Herstellung abschirmender Garne wurde überraschenderweise festgestellt, dass oberflächlich glatte Multifilamentgarne beim Umwinden eines Kernfadens ihren ursprünglich radialen Querschnitt aufgeben und sich parallel nebeneinander entlang des Kernfadens ausrichten. Dadurch wird die von leitfähigen Filamenten bedeckte Gesamtfläche im Vergleich zu monofilen Filamenten stark erhöht, was wiederum zu einer deutlichen Verbesserung der Abschirmung elektromagnetischer Strahlung führt.

Da sich die Abschirmeigenschaften mit einer zunehmenden Zahl an Einzelfilamenten verbessern, werden elektrisch leitfähige Multifilamentgarne bevorzugt, die wenigstens 3, besonders bevorzugt wenigstens 4 und insbesondere wenigstens 5 Einzelfilamente umfassen. Gemäß weiteren besonders bevorzugten Ausführungsformen der vorliegenden Erfindung weist das elektrisch leitfähige Multifilamentgarn wenigstens 10, bevorzugt wenigstens 15, besonders bevorzugt wenigstens 20 Einzelfilamente auf. Ganz besonders bevorzugt werden elektrisch leitfähige Multifilamentgarne mit wenigstens 25, insbesondere wenigstens 35 und ganz besonders bevorzugt wenigstens 50 Einzelfilamenten.

Mit zunehmender Zahl an leitfähigen Einzelfilamenten gehen allerdings die textilen Eigenschaften des Garns immer mehr verloren. Daher werden elektrisch leitfähige Multifilamentgarne bevorzugt, die maximal 500, besonders bevorzugt maximal 400 und ganz besonders bevorzugt maximal 300 Einzelfilamente umfassen. Gemäß weiteren besonders bevorzugten Ausführungsformen der vorliegenden Erfindung weist das elektrisch leitfähige Multifilamentgarn maximal 250, besonders bevorzugt maximal 200 und ganz besonders bevorzugt maximal 150 Einzelfilamente auf. Ganz besonders bevorzugt werden elektrisch leitfähige Multifilamentgarne mit maximal 125, insbesondere maximal 100 und insbesondere bevorzugt maximal 75 Einzelfilamenten verwendet.

Im Hinblick auf die beiden gewünschten Eigenschaften, nämlich effiziente Abschirmung elektromagnetischer Felder und gute textile Eigenschaften umfasst das elektrisch leitfähige Multifilamentgarn ein metallisiertes, textiles Multifilamentgarn. Besonders gute Eigenschaften weisen auch metallisch beschichtete Synthesefilamente sowie silberbeschichtete Filamente auf. Daneben werden silberbeschichtete Nylonfilamente sowie Edelstahlfilamente bevorzugt verwendet. Gemäß einer bevorzugten Ausführungsform der vorliegenden Erfindung umfasst das elektrisch leitfähige Multifilamentgarn zumindest eines der genannten Filamente. Für zahlreiche Applikationen bietet sich auch die Verwendung silberbeschichteter synthetischer Garne als elektrisch leitfähiges Multifilamentgarn an. Besonders eignen sich waschbeständige, silberbeschichtete Nylongarne zur Herstellung der erfindungsgemäßen Garne.

Insbesondere bevorzugt werden Ausführungsformen, die metallisierte Multifilamentgarne mit 2 bis 80 Einzelfilamenten oder Edelstahlmultifilamentgarne mit 2 bis 100 Einzelfilamenten umfassen. Typischerweise bewegt sich die Dicke eines einzelnen Edelstahl-Filaments im Bereich zwischen 0,002 mm und 0,02 mm. Zum Einsatz als elektrisch leitfähiges Multifilamentgarn ebenfalls geeignet sind Kohlenstoff gefüllte Multifilamentgarne, Metall/Textil-Stapelgarne, leitfähig gefüllte Synthesefasern sowie aus leitfähigen Polymeren gefertigte Multifilamentgarne.

Als leitfähige Einzelfilamente der elektrisch leitfähigen Multifilamentgarne eignen sich auch metallische Drähte, Drahtzwirne oder -geflechte, leitend beschichtete Synthesefasern und Stapelgarne mit Metallanteil. Die leitfähigen Filamente können einfach oder mehrfach, sortenrein oder gemischt eingesetzt werden, d. h., ein elektrisch leitfähiges Multifilamentgarn kann eine oder mehrere Arten von Einzelfilamenten umfassen.

Gemäß einer bevorzugten Ausführungsform der vorliegenden Erfindung weisen die Einzelfilamente des elektrisch leitfähigen Multifilamentgarns einen Durchmesser zwischen 0,01 und 0,1 mm, bevorzugt zwischen 0,02 und 0,06 mm, besonders bevorzugt zwischen 0,03 und 0,05 mm auf.

Ebenfalls bevorzugt sind Ausführungsformen, bei denen das elektrisch leitfähige Multifilamentgarn pro Meter Garn mindestens 250-mal, bevorzugt mindestens 500-mal, besonders bevorzugt mindestens 1000-mal um den Kernfaden gewickelt ist.

Zusätzlich zur elektrisch leitfähigen Umwindung umfasst das Garn einen äußeren Umwindefaden. Eine derartige Umwindung kann verschiedene Funktionen übernehmen. Beispielhaft seien genannt: Mechanischer Abriebschutz, Verbesserung der Verarbeitbarkeit des Garns auf schnell laufenden Maschinen, Farbe, Glanz, Optik, Griff, Haptik, Überdehnschutz, Reißfestigkeit, Ausgleich der inneren Torsionsspannung des Garns nach Umwindung in einer Richtung.

Durch den äußeren Umwindefaden wird insbesondere ein guter textiler Tragekomfort erreicht. Die äußere Umwindung sorgt also für eine textile Optik und Haptik. Die als äußere Umwindefäden verwendeten Materialien können je nach beabsichtigtem Einsatz in weiten Grenzen variiert werden. Gemäß einer bevorzugten Ausführungsform des erfindungsgemäßen Garns werden Multifilamentgarne als äußere Umwindung eingesetzt. Abhängig von der Applikation können sich für die äußere Umwindung aber alle möglichen Filamente eignen. Stellvertretend für die möglichen Materialien seien beispielhaft genannt: Nylon, Polyester, Viskose, Polyamid, Leinen, Wolle, Seide, Baumwolle, Polypropylen, Kevlar in den verschiedenen Ausführungsformen, Mischgarne aller Art sowie metallisierte Garne wie z. B. silberbeschichtetes Nylon.

Im Rahmen der vorliegenden Erfindung werden Ausführungsformen bevorzugt, bei denen der Umwindefaden pro Meter Garn mindestens 250-mal, bevorzugt mindestens 500-mal, besonders bevorzugt mindestens 1000-mal um das elektrisch leitfähige Multifilamentgarn gewickelt ist.

Die vorliegende Erfindung umfasst außerdem Gewebe, Gestricke und Gewirke zur Abschirmung von elektromagnetischer Strahlung, welche wenigstens ein erfindungsgemäßes Garn umfassen. Besonders bevorzugt ist es im Rahmen der vorliegenden Erfindung, wenn Kette und Schuss des Gewebes, Gestricks oder Gewirks jeweils wenigstens ein erfindungsgemäßes Garn umfassen.

Vorteilhaft für die abschirmende Wirkung des Gewebes, Gestricks oder Gewirks ist eine nicht vollständige Abdeckung des elektrisch leitfähigen Multifilamentgarns durch den äußeren Umwindefaden. Durch die Lücken in der Abdeckung kommt es im Gewebe zum elektrischen Kontakt zwischen den elektrisch leitfähigen Multifilamentgarnen verschiedener Garne. Der elektrische Kontakt der einzelnen Garne untereinander verbessert die abschirmende Wirkung erheblich. Der Einsatz der abschirmenden Garne in Kette und Schuss ist also besonders vorteilhaft für die Abschirmung. Daher sind im Rahmen der vorliegenden Erfindung Ausführungsformen ganz besonders bevorzugt, bei denen Kette und Schuss eines Gewebes, Gestricks oder Gewirks so miteinander verwebt sind, dass Kette und Schuss im elektrischen Kontakt miteinander stehen.

Die vorliegende Erfindung umfasst außerdem textile Produkte zur Abschirmung von elektromagnetischer Strahlung, die wenigstens ein Gewebe, Gestrick oder Gewirk umfassen, welche wiederum wenigstens ein erfindungsgemäßes Garn umfassen. Bevorzugte Beispiele solcher textilen Produkte sind Futterstoffe, Baldachine, Bettwäsche, Unterwäsche, HF-Schutzanzüge und Vorhänge sowie zur Körperseite abschirmende Taschen.

Die vorliegende Erfindung umfasst außerdem die Verwendung eines erfindungsgemäßen Garns, eines Gewebes, Gestricks, Gewirks oder eines textilen Produkts zur Abschirmung von elektromagnetischer Strahlung.

### Kurze Beschreibung der Zeichnungen

Nachfolgend soll die Erfindung anhand von Ausführungsbeispielen im Zusammenhang mit den Figuren näher erläutert werden, es wird aber ausdrücklich darauf hingewiesen, dass die Erfindung nicht auf die angegebenen Beispiele beschränkt sein soll. Es zeigen
- Fig. 1: eine schematische Darstellung eines erfindungsgemäßen Garns zur Abschirmung von elektromagnetischer Strahlung;
- Fig. 2: eine Projektion durch ein aus dem in Figur 1 dargestellten Garn gefertigtes Gewebe; gezeigt sind lediglich die elektrisch leitfähigen Multifilamentgarne;
- Fig. 3: eine schematische Darstellung eines erfindungsgemäßen Garns zur Abschirmung von elektromagnetischer Strahlung;
- Fig. 4: eine Projektion durch ein aus dem in Figur 3 dargestellten Garn gefertigtes Gewebe; gezeigt sind lediglich die elektrisch leitfähigen Multifilamentgarne;
- Fig. 5: Auftragung der durch ein erfindungsgemäßes Gewebe verursachten Dämpfung elektromagnetischer Strahlung in Abhängigkeit von der Frequenz der Strahlung.

### Wege zur Ausführung der Erfindung

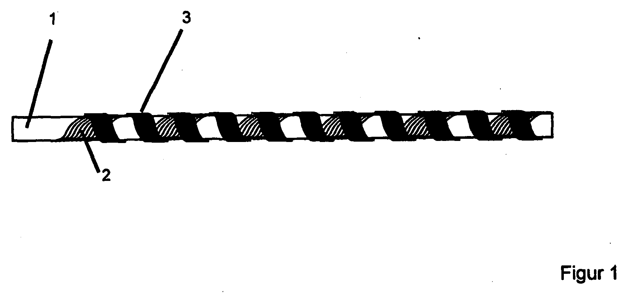

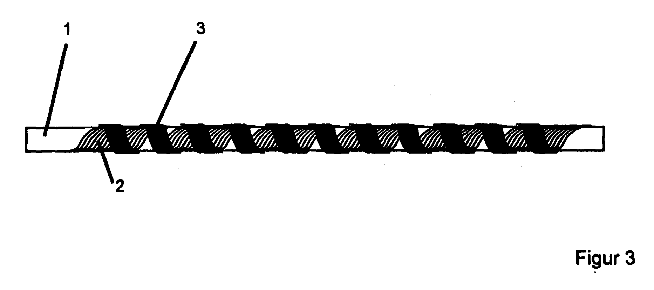

Wie aus den Figuren 1 und 3 zu ersehen ist, umfasst das erfindungsgemäße Garn einen Kernfaden 1, ein elektrisch leitfähiges Multifilamentgarn 2 und einen äußeren Umwindefaden 3.

In Figur 1 ist ein elektrisch leitfähiges Multifilamentgarn 2 mit 10 Einzelfilamenten dargestellt. In Figur 3 besitzt das elektrisch leitfähige Multifilamentgarn 16 Einzelfilamente. Die parallele Anordnung der Einzelfilamente des elektrisch leitfähigen Multifilamentgarns bewirkt im Vergleich zur Einarbeitung eines einzelnen Filaments eine deutliche Erhöhung der abschirmenden Fläche.

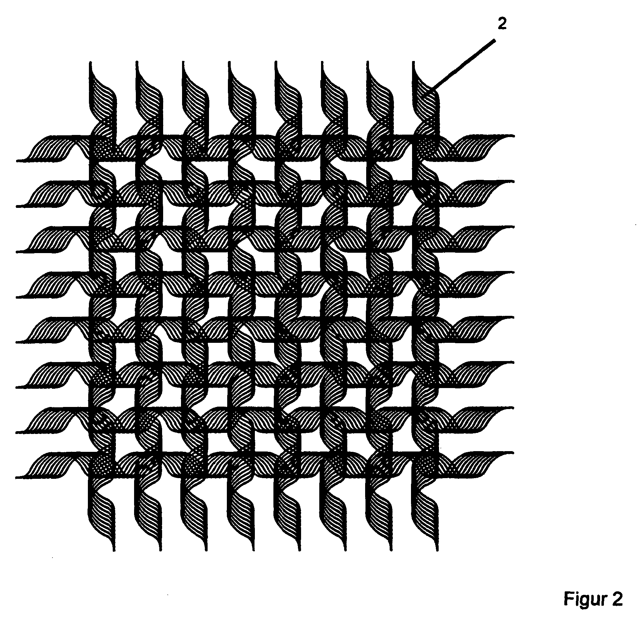

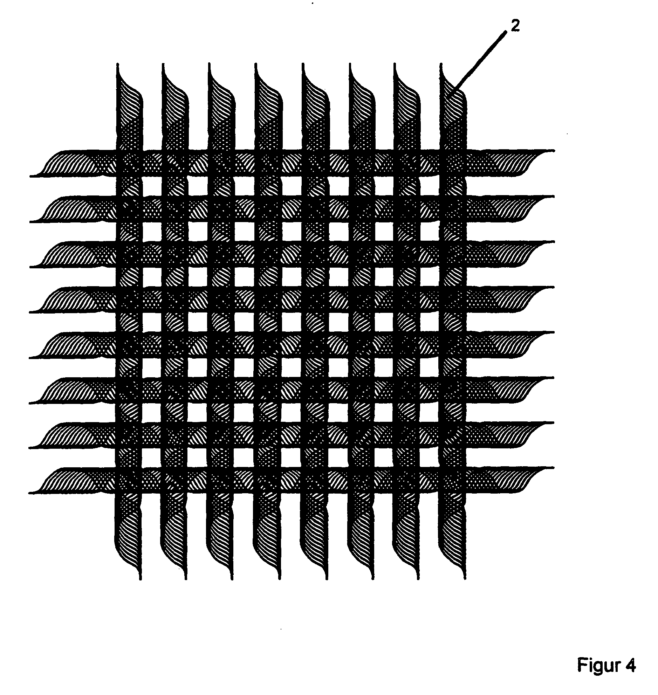

Besonders deutlich wird dieser Sachverhalt, wenn man die Anordnung der abschirmenden Garne in der Projektion durch ein aus derartigen Garnen gefertigtes Gewebe betrachtet. In den Figuren 2 und 4 sind solche Projektionen durch abschirmende Gewebe schematisch dargestellt. Gezeigt sind lediglich die elektrisch leitfähigen Multifilamentgarne 2 ohne die Kernfäden 1 und die äußeren Umwindefäden 3.

In Figur 2 ist die Projektion durch ein aus dem in Figur 1 abgebildeten Garn hergestelltes Gewebe zu sehen. In Figur 4 wird das Garn aus Figur 3 verwendet. Physikalisch wirkt die in Figur 4 dargestellte Abschirmung wie eine Abschirmung, die aus Metalldrähten mit dem Durchmesser der inneren Umwindung besteht.

In den Figuren 2 und 4 ist die durch Verwendung von elektrisch leitfähigen Multifilamentgarnen im Vergleich zu monofilen Garnen deutlich erhöhte abschirmende Fläche zu erkennen.

### Beispiel 1:

Ein Polyester-Multifilamentgarn mit 100 dtex und 36 Einzelfilamenten wird auf einer Garnumwindemaschine durch eine Hohlspindel geführt. Diese Hohlspindel trägt eine konische Garnspindel, von der über Kopf ein versilbertes Nylon-Multifilamentgarn mit 30 den, bestehend aus 10 Einzelfilamenten abgezogen wird. Das mit dem abschirmenden Material einfach umwundene Garn wird durch eine zweite Hohlspindel geführt. Diese Hohlspindel trägt ein handelsübliches Multifilament-Polyamidgarn aus PA66 mit 3 dtex, bestehend aus 10 Einzelfilamenten. Das PA66 Garn wird gegenläufig zum abschirmenden Garn um den Kern gewickelt. Die Maschinenparameter werden so ausgewählt, dass ein ausgewogenes Garn entsteht, das möglichst frei von inneren Torsionsspannungen ist. Das äußere PA66 Garn ist etwa 1600 mal pro Meter Garn um den Kern gewunden; die innere Umwindung ist ebenfalls etwa 1600 mal pro Meter Garn um den Kern gewunden. Die innere Umwindung ist annähernd vollständig von dem außen liegenden PA66 Garn bedeckt, so dass das Garn neben einer ausgezeichneten elektrischen Leitfähigkeit auch über textile Optik und Haptik verfügt.

### Beispiel 2:

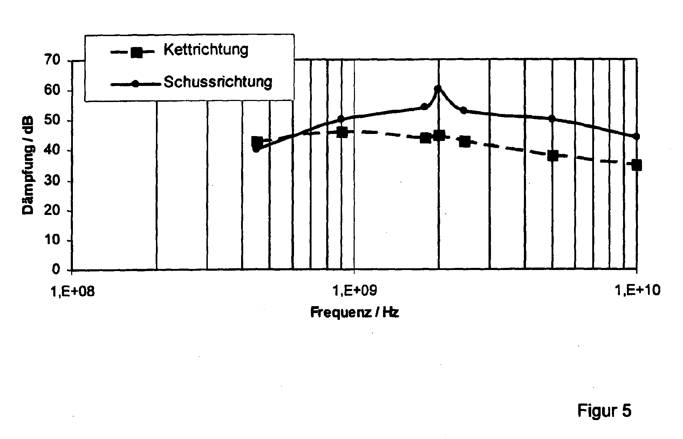

Das elektrisch leitende Verbundgarn aus Beispiel 1 wird auf einer handelsüblichen Webmaschine als Kett- und Schussfaden eingesetzt. Dabei entsteht ein leichtes, festes Gewebe in Leinenbindung. Das Gewebe fühlt sich textil an. Es zeigt eine ansprechende silbrig grau melierte Oberfläche. Das Gewebe ist zum Einsatz in Taschen oder als leichtes Obermaterial geeignet. Ein 50 cm x 50 cm großes Stück des Gewebes wurde auf seine abschirmende Wirkung im magnetischen Nahfeld nach IEEE-Standard 299-1997, MIL-Standard 285 und VG-Norm 95 370 Part 15 im Frequenzbereich von 450 MHz bis 10.000 MHz untersucht. Dabei werden Schirmmessungen mit polarisierten Feldern parallel der Schussrichtung und parallel der Kettrichtung des Gewebes durchgeführt. Die Ergebnisse der Messungen sind in Figur 5 dargestellt. Das Gewebe weist eine sehr gute Dämpfung von mehr als 40 dB bereits bei niedrigen Frequenzen auf.

### Beispiel 3:

Ein Polyester Multifilamentgarn mit 100 dtex und 36 Einzelfilamenten wird auf einer Garnumwindemaschine durch eine Hohlspindel geführt. Diese Hohlspindel trägt eine konische Garnspindel, von der über Kopf ein Edelstahl-Multifilamentgarn vom Typ Bekinox VN 14/1x90/100Z abgezogen wird. Das mit dem abschirmenden Material einfach umwundene Garn wird durch eine zweite Hohlspindel geführt. Diese Hohlspindel trägt ein handelsübliches Multifilament-Polyamidgarn aus PA66 mit 78 dtex, bestehend aus 34 Einzelfilamenten. Das PA66 Garn wird gegenläufig zum abschirmenden Garn um den Kern gewickelt. Die Maschinenparameter werden so ausgewählt, dass ein ausgewogenes Garn entsteht, das möglichst frei von inneren Torsionsspannungen ist. Das äußere PA66 Garn ist etwa 2000 mal pro Meter Garn um den Kern gewunden; die innere Umwindung ist etwa 600 mal pro Meter Garn um den Kern gewunden. Die innere Umwindung ist annähernd vollständig von dem außen liegenden PA66 Garn bedeckt, so dass das Garn neben einer ausgezeichneten elektrischen Leitfähigkeit auch über textile Optik und Haptik verfügt.

## Patentansprüche

1. Garn zur Abschirmung von elektromagnetischer Strahlung, umfassend zumindest einen Kernfaden (1), zumindest ein, um den Kernfaden (1) gewundenes elektrisch leitfähiges Multfilamentgarn (2) und zumindest einen, um den mit dem elektrisch leitfähigen Multifilamentgarn (2) umwundenen Kernfaden (1) gewundenen äußeren Umwindefaden (3), wobei das elektrisch leitfähige Multifilamentgarn (2) aus wenigstens zwei im Wesentlichen parallel laufenden Einzelfilamenten besteht **dadurch gekennzeichnet, dass** das elektrisch leitfähige Muttifitamentgarn (2) ein metallisiertes, textiles Multifilamentgarn umfasst.

2. Garn nach Anspruch 1, **dadurch gekennzeichnet, dass** das elektrisch leitfähige Multfitamentgarn (2) metallisch beschichtete Synthesefilamente umfasst.

3. Garn nach Anspruch 1 oder 2, **dadurch gekennzeichnet, dass** das elektrisch leitfähige Multifilamentgarn (2) silberbeschichtete Filamente umfasst.

4. Garn nach Anspruch 3, **dadurch gekennzeichnet, dass** das elektrisch leitfähige Multifilamentgarn (2) silberbeschichtete Nylonfilamente umfasst.

5. Garn nach einem der vorhergehenden Ansprüche, **dadurch gekennzeichnet, dass** das elektrisch leitfähige Multifilamentgarn (2) Edelstahlfilamente umfasst.

6. Garn nach einem der vorhergehenden Ansprüche, **dadurch gekennzeichnet, dass** das elektrisch leitfähige Multifilamentgarn (2) wenigstens 3, bevorzugt wenigstens 4, besonders bevorzugt wenigstens 5 Einzelfilamente umfasst.

7. Garn nach einem der vorhergehenden Ansprüche, **dadurch gekennzeichnet, dass** das elektrisch leitfähige Multifilamentgarn (2) wenigstens 10, bevorzugt wenigstens 15, besonders bevorzugt wenigstens 20 Einzelfilamente umfasst.

8. Garn nach einem der vorhergehenden Ansprüche, **dadurch gekennzeichnet, dass** das elektrisch leitfähigen Multifilamentgarn (2) wenigstens 25, bevorzugt wenigstens 35, besonders bevorzugt wenigstens 50 Einzelfilamente umfasst.

9. Garn nach einem der vorhergehenden Ansprüche, **dadurch gekennzeichnet, dass** das elektrisch leitfähige Multifilamentgarn (2) maximal 500, bevorzugt maximal 400, besonders bevorzugt maximal 300 Einzelfilamente umfasst.

10. Garn nach einem der vorhergehenden Ansprüche, **dadurch gekennzeichnet, dass** das elektrisch leitfähige Multifilamentgarn (2) maximal 250, bevorzugt maximal 200, besonders bevorzugt maximal 150 Einzelfilamente umfasst.

11. Garn nach einem der vorhergehenden Ansprüche, **dadurch gekennzeichnet, dass** das elektrisch leitfähige Multifilamentgarn (2) maximal 125, bevorzugt maximal 100, besonders bevorzugt maximal 75 Einzelfilamente umfasst.

12. Garn nach einem der vorhergehenden Ansprüche, **dadurch gekennzeichnet, dass** die Einzelfilamente des elektrisch leitfähigen Multifilamentgarns (2) einen Durchmesser zwischen 0,01 und 0,1 mm, bevorzugt zwischen 0,02 und 0,06 mm, besonders bevorzugt zwischen 0,03 und 0,05 mm aufweisen.

13. Garn nach einem der vorhergehenden Ansprüche, **dadurch gekennzeichnet, dass** das elektrisch leitfähige Multifilamentgarn (2) pro Meter Garn mindestens 250-mal, bevorzugt mindestens 500-mal, besonders bevorzugt mindestens 1000-mal um den Kernfaden gewickelt ist.

14. Garn nach einem der vorhergehenden Ansprüche, **dadurch gekennzeichnet, dass** der Umwindefaden (3) pro Meter Garn mindestens 250-mal, bevorzugt mindestens 500-mal, besonders bevorzugt mindestens 1000-mal um das elektrisch leitfähige Multifilamentgarn (2) gewickelt ist.

15. Gewebe, Gestrick oder Gewirk zur Abschirmung von elektromagnetischer Strahlung, umfassend wenigstens ein Garn gemäß einem der vorhergehenden Ansprüche.

16. Gewebe, Gestrick oder Gewirk nach Anspruch 15, **dadurch gekennzeichnet, dass** Kette und Schuss jeweils wenigstens ein Garn gemäß einem der vorhergehenden Ansprüche umfassen.

17. Gewebe, Gestrick oder Gewirk nach Anspruch 16, **dadurch gekennzeichnet, dass** Kette und Schuss so miteinander verwebt sind, dass Kette und Schuss im elektrischen Kontakt miteinander stehen.

18. Textile Produkte zur Abschirmung von elektromagnetischer Strahlung umfassend wenigstens ein Gewebe, Gestrick oder Gewirk gemäß den Ansprüchen 15 bis 17.

19. Textile Produkte nach Anspruch 18, nämlich Futterstoffe, Baldachine, Bettwäsche, Unterwäsche, HF-Schutzanzüge und Vorhänge sowie zur Körperseite abschirmende Taschen.

20. Verwendung eines Garns wie in den Ansprüchen 1 bis 14 definiert, eines Gewebes, Gestricks oder Gewirks gemäß den Ansprüchen 15 bis 17 oder eines textilen Produkts gemäß den Ansprüchen 18 und 19 zur Abschirmung von elektromagnetischer Strahlung.

## Claims

1. A yarn for shielding electromagnetic radiation, comprising at least one core thread (1), at least one electrically conductive multifilament yarn (2) that is wound around the core thread (1), and at least one outer binding thread (3) that is wound around the core thread (1) enwound with the electrically conductive multifilament yarn (2), the electrically conductive multifilament yarn (2) comprising at least two substantially parallel individual filaments, **characterized in that** the electrically conductive multifilament yarn (2) comprises a metallized, textile multifilament yarn.

2. The yarn according to claim 1, **characterized in that** the electrically conductive multifilament yarn (2) comprises metallic-coated synthetic filaments.

3. The yarn according to claim 1 or 2, **characterized in that** the electrically conductive multifilament yarn (2) comprises silver-coated filaments.

4. The yarn according to claim 3, **characterized in that** the electrically conductive multifilament yarn (2) comprises silver-coated nylon filaments.

5. The yarn according to one of the preceding claims, **characterized in that** the electrically conductive multifilament yarn (2) comprises stainless steel filaments.

6. The yarn according to one of the preceding claims, **characterized in that** the electrically conductive multifilament yarn (2) comprises at least 3, preferably at least 4, particularly preferably at least 5 individual filaments.

7. The yarn according to one of the preceding claims, **characterized in that** the electrically conductive multifilament yarn (2) comprises at least 10, preferably at least 15, particularly preferably at least 20 individual filaments.

8. The yarn according to one of the preceding claims, **characterized in that** the electrically conductive multifilament yarn (2) comprises at least 25, preferably at least 35, particularly preferably at least 50 individual filaments.

9. The yarn according to one of the preceding claims, **characterized in that** the electrically conductive multifilament yarn (2) comprises a maximum of 500, preferably a maximum of 400, particularly preferably a maximum of 300 individual filaments.

10. The yarn according to one of the preceding claims, **characterized in that** the electrically conductive multifilament yarn (2) comprises a maximum of 250, preferably a maximum of 200, particularly preferably a maximum of 150 individual filaments.

11. The yarn according to one of the preceding claims, **characterized in that** the electrically conductive multifilament yarn (2) comprises a maximum of 125, preferably a maximum of 100, particularly preferably a maximum of 75 individual filaments.

12. The yarn according to one of the preceding claims, **characterized in that** the individual filaments of the electrically conductive multifilament yarn (2) exhibit a diameter between 0.01 and 0.1 mm, preferably between 0.02 and 0.06 mm, particularly preferably between 0.03 and 0.05 mm.

13. The yarn according to one of the preceding claims, **characterized in that**, per meter of yarn, the electrically conductive multifilament yarn (2) is wrapped around the core thread at least 250 times, preferably at least 500 times, particularly preferably at least 1,000 times.

14. The yarn according to one of the preceding claims, **characterized in that**, per meter of yarn, the binding thread (3) is wrapped around the electrically conductive multifilament yarn (2) at least 250 times, preferably at least 500 times, particularly preferably at least 1,000 times.

15. A woven, knitted or interlaced fabric for shielding electromagnetic radiation, comprising at least one yarn according to one of the preceding claims.

16. The woven, knitted or interlaced fabric according to claim 15, **characterized in that** the warp and weft each comprise at least one yarn according to one of the preceding claims.

17. The woven, knitted or interlaced fabric according to claim 16, **characterized in that** the warp and weft are interwoven with one another such that the warp and weft are in electrical contact with one another.

18. Textile products for shielding electromagnetic radiation, comprising at least one woven, knitted or interlaced fabric according to claims 15 to 17.

19. Textile products according to claim 18, namely linings, canopies, bed linens, underwear, RF protective suits and curtains, as well as body shielding pockets.

20. Use of a yarn as defined in claims 1 to 14, a woven, knitted or interlaced fabric according to claims 15 to 17, or a textile product according to claims 18 and 19 for shielding electromagnetic radiation.

## Revendications

1. Fil de protection contre le rayonnement électromagnétique, comprenant au moins un fil d'âme (1), au moins un fil multifilament (2) conducteur de l'électricité, enroulé autour du fil d'âme (1) et au moins un fil d'enroulement extérieur (3) enroulé autour du fil d'âme (1) entouré lui-même du fil multifilament conducteur de l'électricité (2), dans lequel le fil multifilament conducteur de l'électricité (2) est composé d'au moins deux filaments élémentaires courant sensiblement parallèlement, **caractérisé en ce que** le fil multifilament conducteur de l'électricité (2) comprend un fil multifilament textile métallisé.

2. Fil selon la revendication 1, **caractérisé en ce que** le fil multifilament conducteur de l'électricité (2) comprend des filaments de synthèse revêtus de métal.

3. Fil selon la revendication 1 ou 2, **caractérisé en ce que** le fil multifilament conducteur de l'électricité (2) comprend des filaments revêtus d'argent.

4. Fil selon la revendication 3, **caractérisé en ce que** le fil multifilament conducteur de l'électricité (2) comprend des filaments de Nylon revêtus d'argent.

5. Fil selon l'une des revendications précédentes, **caractérisé en ce que** le fil multifilament conducteur de l'électricité (2) comprend des filaments d'acier spécial.

6. Fil selon l'une des revendications précédentes, **caractérisé en ce que** le fil multifilament conducteur de l'électricité (2) comprend au moins 3, de préférence au moins 4, de façon particulièrement préférée, au moins 5 filaments élémentaires.

7. Fil selon l'une des revendications précédentes, **caractérisé en ce que** le fil multifilament conducteur de l'électricité (2) comprend au moins 10, de préférence au moins 15, de façon particulièrement préférée, au moins 20 filaments élémentaires.

8. Fil selon l'une des revendications précédentes, **caractérisé en ce que** le fil multifilament conducteur de l'électricité (2) comprend au moins 25, de préférence au moins 35, de façon particulièrement préférée, au moins 50 filaments élémentaires.

9. Fil selon l'une des revendications précédentes, **caractérisé en ce que** le fil multifilament conducteur de l'électricité (2) comprend au maximum 500, de préférence au maximum 400, de façon particulièrement préférée, au maximum 300 filaments élémentaires.

10. Fil selon l'une des revendications précédentes, **caractérisé en ce que** le fil multifilament conducteur de l'électricité (2) comprend au maximum 250, de préférence au maximum 200, de façon particulièrement préférée, au maximum 150 filaments élémentaires.

11. Fil selon l'une des revendications précédentes, **caractérisé en ce que** le fil multifilament conducteur de l'électricité (2) comprend au maximum 125, de préférence au maximum 100, de façon particulièrement préférée, au maximum 75 filaments élémentaires.

12. Fil selon l'une des revendications précédentes, **caractérisé en ce que** les filaments élémentaires du fil multifilament conducteur de l'électricité (2) présentent un diamètre compris entre 0.01 et 0.1 mm, de préférence entre 0.02 et 0.06 mm, de façon particulièrement préférée entre 0.03 et 0.05 mm.

13. Fil selon l'une des revendications précédentes, **caractérisé en ce que** le fil multifilament conducteur de l'électricité (2) est enroulé autour du fil d'âme au moins 250 fois, de préférence au moins 500 fois, de façon particulièrement préférée au moins 1000 fois par mètre du fil.

14. Fil selon l'une des revendications précédentes, **caractérisé en ce que** le fil d'enroulement (3) est enroulé autour du fil multifilament conducteur de l'électricité (2) au moins 250 fois, de préférence au moins 500 fois, de façon particulièrement préférée, au moins 1000 fois par mètre du fil.

15. Tissu, tricot ou étoffe de protection contre le rayonnement électromagnétique, comprenant au moins un fil selon une des revendications précédentes.

16. Tissu, tricot ou étoffe selon la revendication 15, **caractérisé en ce que** la chaîne et la trame comprennent chacune au moins un fil selon une des revendications précédentes.

17. Tissu, tricot ou étoffe selon la revendication 16, **caractérisé en ce que** la chaîne et la trame sont entrelacées entre elles de telle manière que la chaîne et la trame soient en contact électrique entre elles.

18. Produits textiles de protection contre le rayonnement électromagnétique, comprenant au moins un tissu, un tricot ou une étoffe selon les revendications 15 à 17.

19. Produits textiles selon la revendication 18, plus précisément matières de doublure, baldaquins, linge de literie, sous-vêtements, vêtements de protection anti-HF et rideaux ainsi que poches de protection pour le corps.

20. Utilisation d'un fil tel que défini dans les revendications 1 à 14, d'un tissu, d'un tricot ou d'une étoffe selon les revendications 15 à 17, ou d'un produit textile selon les revendications 18 et 19, pour la protection contre le rayonnement électromagnétique.
